# EUROPÄISCHE PATENTSCHRIFT

(11) **EP 0 884 938 B1**
(45) Veröffentlichungstag und Bekanntmachung des Hinweises auf die Patenterteilung: **08.08.2001**
(21) Anmeldenummer: 98110066.2
(22) Anmeldetag: 03.06.1998
(51) Int. Cl.: H05K 5/00, H05K 9/00, B60R 16/02

(54) **Elektronische Baueinheit mit einer metallischen Abschirmung bei einem Anschlussbereich**
Electronic unit provided with metallic shielding in a connection area
Unité électronique avec blindage métallique dans une zone de connexions

(30) Priorität: 14.06.1997 DE 19725242
(43) Veröffentlichungstag der Anmeldung: 16.12.1998
(73) Patentinhaber: TEMIC TELEFUNKEN microelectronic GmbH, 90411 Nürnberg (DE)
(72) Erfinder: Baur, Richard, 85276 Pfaffenhofen (DE); Fendt, Günter, 86529 Schrobenhausen (DE); Schlingmann, Ralf, 86529 Schrobenhausen (DE); Wöhrl, Alfons, 86529 Schrobenhausen (DE)
(74) Vertreter: Maute, Hans-Jürgen, Dipl.-Ing.

(56) Entgegenhaltungen:
- DE-A- 3 835 178

## Beschreibung

Die Erfindung betrifft eine elektronische Baueinheit gemäß dem Oberbegriff des Anspruchs 1.

Bei elektronischen Steuergeräten in der Kraftfahrzeugindustrie, vor allem bei sicherheitskritischen Moduleinheiten, wird auf eine hohe Systemzuverlässigkeit sehr hoher Wert gelegt. Dies beinhaltet auch eine gute Resistenz gegenüber Einstrahlungen, die die elektromagnetische Verträglichkeit (EMV) beeinträchtigen. Im Normalfall wird ein guter EMV-Schutz (d.h. Schutz gegenüber Störungen, die die EMV beeinträchtigen) mittels eines die Kfz-Elektronik-Baugruppe umschließenden Metallgehäuses erzielt. Da man bestrebt ist, zwecks Treibstoffeinsparung in der Kfz-Technik Gewicht einzusparen, sollen die von Zulieferern der Kfz-Industrie gelieferten Teile möglichst leicht an Gewicht sein.

Dies ist einer der Gründe, weshalb man bei den KfZ-Elektronik-Modulen auf Kunststoffgehäuse, die möglicherweise mit einer Metallisierung versehen sind, übergeht. Wo dies nicht möglich ist, werden bei Metallgehäusen nur die allernötigsten Gehäusebestandteile vorgesehen.

Bei Gehäusen wird bisher im Anschlußbereich, insbesondere im Stecker-Eingangsbereich ein sogenannter "EMV-Steg" oder "EMV-Wand" aus Metall vorgesehen, die als zusätzliches Abschirmmittel gegenüber Einstrahlungen dienen soll. Es handelt sich hierbei um eine z.B. an das Metallgehäuse angespritzte Metallwand.

Aus der DE 38 35 178 C2 ist beispielsweise ein derartiges elektrisches Gerät zu entnehmen, bei dem diese zusätzlichen Abschirmmittel zwischen dem Steckerbereich und den Bauelementen durch eine auf der Leiterplatte angeordnete Trennwand realisiert werden, die gleichzeitig als Kühlblock für Leistungsbauelemente verwendet werden.

Wollte man zwecks Gewichtseinsparung auf diese EMV-Wand verzichten, so hätte dies den Nachteil, daß die Schutzwirkung gegen EMV-Einstrahlung im Stecker-Eingangsbereich nicht mehr gewährleistet ist.

Aus der DE 41 13 731 A1 ist darüber hinaus eine elektronische Stehbildkamera bekannt, die neben den für eine Kamera üblichen Systemkomponenten einen Gleichstromumrichter zum Verstärken der von einer Batterie erzeugten Spannung zur Versorgung der Systemkomponenten enthält. Um die Systemkomponenten gegen eine von dem Gleichstromumrichter erzeugte Störstrahlung abzuschirmen, wird die Batterie innerhalb des Gehäuses zwischen dem Gleichstromumrichter und den Systemkomponenten angeordnet, so dass die Batterie diese gegen die Störstrahlung abschirmt.

Der Erfindung liegt die Aufgabe zugrunde, bei weiterhin gutem EMV-Schutz Gewicht einzusparen.

Diese Aufgabe wird gemäß der Erfindung dadurch gelöst, daß die zusätzliche Abschirmung zwischen Anschlußbereich und den sonstigen elektronischen Bauelementen zumindest teilweise durch mindestens ein Bauelement mit Metallgehäuse oder mit einem die Abschirmfunktion des Gehäuses übernehmenden metallischen Bestandteil gebildet ist, welches räumlich zwischen dem Anschlußbereich und den anderen elektronischen Bauelementen angeordnet ist.

Bei solchen elektronischen Baueinheiten sind häufig zahlreiche Elektrolytkondensatoren vorhanden. Diese gibt es in Bauformen, die ein metallisches Gehäuse aufweisen. Diese Elektrolytkondensatoren werden räumlich so angeordnet, daß sie die Funktion der bekannten EMV-Wand übernehmen können, die deshalb teilweise oder ganz entfallen kann. Dabei ist nicht ausgeschlossen, daß auch andere Bauelemente, die über ein metallisches Gehäuse verfügen, als Bestandteil der erfindungsgemäßen Abschirmung eingesetzt werden. Die Metallgehäuse der Elektrolytkondensatoren oder andere Elemente sind normalerweise mit Masse zu verbinden. Sofern solche Elektrolytkondensatoren eingesetzt werden, die kein eigenes sie umhüllendes Metallgehäuse aufweisen, bei denen aber der außen liegende Kondensatorbelag geerdet ist, kann dieser äußere Kondensatorbelag die abschirmende Funktion des Gehäuses übernehmen und ebenfalls zur Abschirmung dienen.

Auch die Verwendung solcher soeben geschilderter Kondensatoren wird als zur Erfindung gehörend angesehen.

Die Erfindung schafft somit ein EMV-Schutzkonzept, bei dem sicher ein EMV-Schutz erzielt wird, ohne daß man den sonst erforderlichen konstruktiven Gehäuseaufwand (EMV-Schutzwand im Steckerbereich) benötigt. Dieses wird dadurch erreicht, daß man die im System erforderlichen Elektrolytkondensatoren im Stecker-Eingangsbereich so anordnet, daß diese die Aufgabe eine EMV-Schutzwand nachbilden.

Mit der Erfindung wird der Vorteil erreicht, daß die elektronische Baueinheit störunanfällig gegenüber EMV-Einstrahlung auf die Elektronik wird und trotzdem der Einsatz von Gehäusen für die elektronische Baueinheit mit minimalem Aufwand ermöglicht wird. Dadurch ergeben sich die weiteren Vorteile von relativ geringen Kosten bei der Gehäuseherstellung, einer Gewichtsreduzierung des Systems und eines Platzgewinns auf der zur Verfügung stehenden Platinenfläche. Der letzte Vorteil folgt daraus, daß derjenige Raum, der bisher von der am Gehäuse angespritzten EMV-Wand eingenommen wurde, nun zur Unterbringung von elektrischen oder elektronischen Komponenten der Baueinheit, z.B. der genannten Elektrolytkondensatoren zur Verfügung steht. Dies kann zu einer weiteren Verkleinerung und Gewichtsreduzierung der Baueinheit beitragen.

Bei einer Ausführungsform der Erfindung ist vorgesehen, daß mehrere Bauelemente mit Metallgehäuse dicht benachbart nebeneinander in einer Reihe zum Zweck des Abschirmens angeordnet sind. Dabei können die Bauelemente geradlinig oder in einer beliebigen Kurzform angeordnet werden. Insbesondere können sich die Metallgehäuse benachbarter Bauelemente elektrisch leitend berühren.

Vorteilhaft kann es sein, wenn die zum Zweck des Abschirmens vorgesehenen Bauelemente mindestens annähernd die gleiche Höhe haben, um auf diese Weise eine über ihre Länge etwa gleich hohe "Wand" zu bilden. Zur Verwirklichung kann es erforderlich sein, bisher vorhandene, im Bereich der Schaltung verteilte Elektrolytkondensatoren durch andere mit abweichenden räumlichen Abmessungen zu ersetzen.

Elektrolytkondensatoren haben häufig eine kreiszylindrische Gestalt. Sofern Elektrolytkondensatoren mit einer hiervon abweichenden Gestalt zur Verfügung stehen, kann die möglichst lückenlose Aneinanderreihung zwecks Abschirmung dadurch unterstützt werden, daß einer oder mehrere der genannten Elektrolytkondensatoren in geeigneter Drehstellung montiert wird, damit er in der Längsrichtung der Wand gesehen die gewünschte Länge seines Gehäuses aufweist.

Weitere Merkmale und Vorteile der Erfindung ergeben sich aus der nachfolgenden Beschreibung von Ausführungsbeispielen der Erfindung anhand der Zeichnung, die erfindungswesentliche Einzelheiten zeigt, und aus den Ansprüchen. Die einzelnen Merkmale können je einzeln für sich oder zu mehreren in beliebigen Kombination bei einer Ausführungsform der Erfindung verwirklicht sein. Es zeigen:
- Fig. 1: eine Draufsicht auf eine gedruckte Schaltung einer elektronischen Baueinheit, bei der eine Anzahl von Elektrolytkondensatoren in der Nähe eines Anschlußbereichs zwecks Bildung einer Abschirmung angeordnet ist, gemäß einem ersten Ausführungsbeispiel,
- Fig. 2: einen Längsschnitt durch ein zweites Ausführungsbeispiel, bei dem ein die Leiterplatte umgebendes Gehäuse gezeigt ist, und
- Fig. 3: einen Längsschnitt durch eine prinzipiell bekannte elektronische Baueinheit mit Metallgehäuse, an welches eine EMV-Schutzwand angespritzt ist.

In Fig. 3 trägt eine Leiterplatte 1 verschiedene elektronische Bauelemente 2, 3, 4, von denen das Bauelement 3 ein Elektrolytkondensator sein mag. Die Leiterplatte 1 mit den von ihr getragenen Bauteilen ist von einem metallischen Gehäuse umschlossen, das ein oberes Gehäuseteil 6 aufweist, das im Druckguß hergestellt ist und die Oberseite der Schaltung überdeckt; all der Unterseite der Leiterplatte 1 ist ein metallischer Deckel 8 vorgesehen, der mit dem Gehäuseteil 6 verschraubt ist. Das Gehäuseteit 6 weist eine angespritzte EMV-Schutzwand 10 auf, die im Beispiel rechts von den Bauelementen 2 3, 4 angeordnet ist. Auf der den Bauelementen 2, 3, 4 abgewandten Seite der EMV-Schutzwand 10 ist eine Steckvorrichtung 12 zur Verbindung mit Stromversorgungsleitungen und Signalleitungen vorgesehen. Somit verhindert bei der bekannten Anordnung die EMV-Schutzwand 10, die zusammen mit der zur Leiterplatte 1 gerichteten Einbuchtung 14 des Bodens 8 und dem übrigen Gehäuse eine nahezu vollständige Einkapselung der elektronischen Bauteile 2, 3, 4 bewirkt, daß keine Einstrahlungen vom Bereich des Steckers 12 her zu den elektronischen Bauelementen oder in umgekehrter Richtung gelangen können.

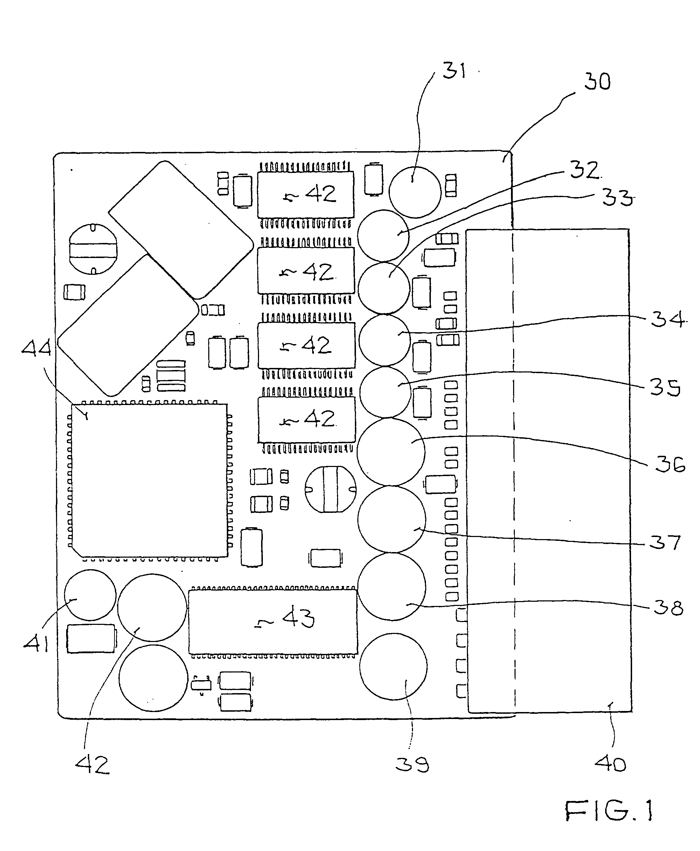

Bei dem in Fig. 1 gezeigten Beispiel einer erfindungsgemäßen Anordnung, bei der lediglich die Leiterplatte 30 und der Steckerbereich gezeigt ist, ein Gehäuse jedoch zur Zeichnungsvereinfachung nicht dargestellt ist, kann die als Teil des Gehäuses ausgebildete EMV-Schutzwand der Fig. 3 entfallen. Bei der erfindungsgemäßen Anordnung sind nämlich von den zahlreichen in der Schaltung benötigten Elektrolytkondensatoren die Elektrolytkondensatoren 31 bis 39 in einer geraden Reihe dichtestmöglich nebeneinander in der Nähe eines Anschlußsteckers 40 angeordnet und bilden mit ihren Metallgehäusen, die jeweils mit Masse verbunden sind, die Abschirmung gegenüber in die Schaltung eindringenden und aus dieser austretenden Strahlungen. Es ist auch möglich die Elektrolytkondensatoren in jeder beliebigen Kurvenform anzuordnen, um den räumlichen Gegebenheiten auf der Leiterplatte 30 und im Bereich des Anschlußsteckers 40 gerecht zu werden. Auf diese Weise wird ein guter EMV-Schutz gewährleistet. im Beispiel ist die Sachlage so, daß noch zwei weitere Elektrolytkondensatoren 41 und 42 in der Schaltung vorhanden sind, die nicht für die durch die Elektrolytkondensatoren 31 bis 39 gebildete Schutzwand benötigt werden. Die elektronische Schaltung weist zahlreiche, vom Stecker 40 aus gesehen hinter den Elektrolytkondensatoren 31 bis 39 angeordnete elektronische Halbleiterelemente, nämlich unter anderem integrierte Schaltungen 42, 43 und 44 auf. Einige nicht störungsanfällige Halbleiterelemente, im Beispiel Dioden, befinden sich zwischen dem Stecker 40 und den Elektrolytkondensatoren 31 bis 39.

Elektrolytkondensatoren dienen im allgemeinen dazu, Leitungen frei von relativ niederfrequenten Frequenzen zu halten, also insbesondere dazu, Versorgungsgleichspannungen von überlagerten Frequenzen zu befreien. Daher ist es in vielen Fällen möglich, ohne irgendeine Beeinträchtigung der Funktion die Elektrolytkondensatoren über etwas längere Leitungen (im Vergleich dazu, daß sie an der herkömmlich vorgesehenen Stelle in der Schaltung angebracht wären) anzuschließen.

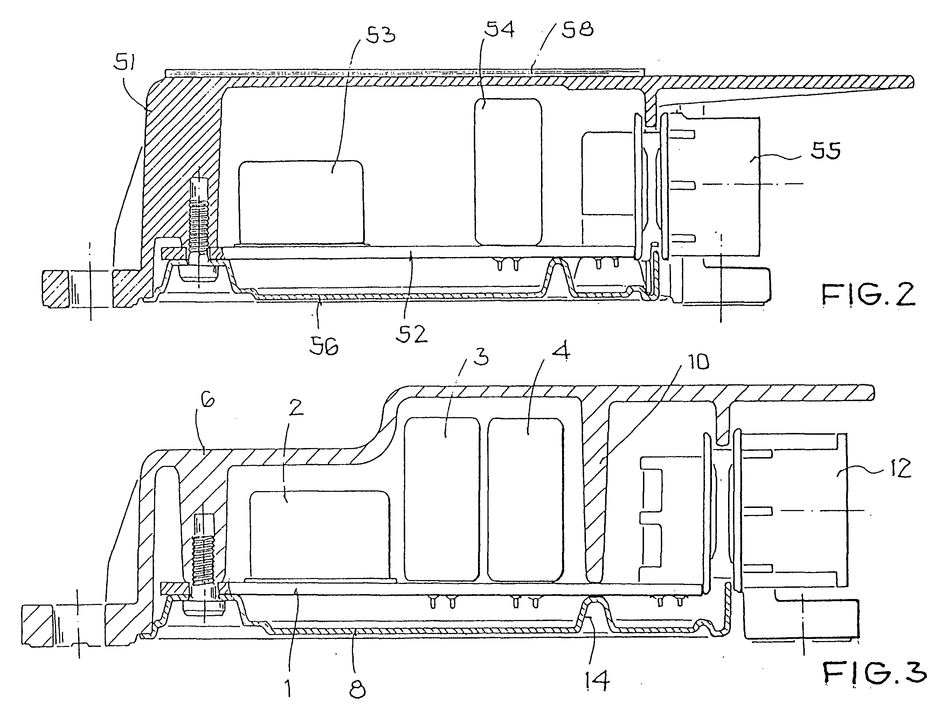

Die in Fig. 1 gezeigte elektronische Baueinheit kann noch von einem Kunststoffgehäuse, das bei Bedarf auch eine Metallisierung tragen kann, eingeschlossen sein. Die Elektrolytkondensatoren 31 bis 39 sind so ausgewählt, daß sie rechtwinklig zur Zeichenebene der Fig. 2 eine für alle Kondensatoren etwa gleiche Höhe aufweisen, und bis dicht an das genannte Gehäuse heranreichen. Auf diese weise wird eine perfekte Abschirmung erzielt.

Fig. 2 zeigt in einer mit der Fig. 3 vergleichbaren Ansicht einen Längsschnitt durch eine erfindungsgemäße Anordnung, die in einem Gehäuse untergebracht ist. Das Gehäuse besteht hier aus einem aus Kunststoff gespritzten Oberteil 51, an dem eine Leiterplatte 52 befestigt ist, die elektrische und elektronische Komponenten 53 und 54 trägt. Bei der Komponente 54 handelt es sich um einen Elektrolytkondensator, der einer von mehreren in einer Reihe in Blickrichtung der Fig. 2 hintereinander angeordneten Elektrolytkondensatoren ist, die wie bei der Anordnung nach Fig. 1 mit ihren Gehäusen eine Abschirmwand bilden. In Fig. 2 rechts von den Elektrolytkondensatoren 54 befindet sich ein Stecker 55, der die elektrische Verbindung zu Signalleitungen und Stromversorgungsleitungen herstellt. Die Unterseite der Leiterplatte 52 ist durch ein Unterteil 56 des Gehäuses aus einem dünnen Metallblech abgedeckt, das an dem Oberteil 51 befestigt ist.

An der Oberseite des Oberteils 51 ist außen eine dünnen Metallschicht 58 als Abschirmung gegen den Einfall elektromagnetischer Strahlung von oben angebracht, auf die verzichtet werden kann, wenn entsprechende EMV-Bedingungen vorliegen oder wenn das Oberteil 51 aus Metall gefertigt ist. Der Schutz gegen das Eindringen elektromagnetischer Strahlung vom Bereich des Steckers 55 her wird durch die Komponenten 54 (Elektrolytkondensatoren) bewirkt, deren Gehäuse mittels Anschlüssen der Leiterplatte 52 mit Masse verbunden sind.

Bei den Anordnungen der Fig. 1 und 2 handelt es sich um elektronische Module für Kraftfahrzeuge.

## Patentansprüche

1. Elektronische Baueinheit, die aufweist:
a) eine Anzahl von elektronischen Bauelementen,
b) ein Gehäuse (51,56) zur Aufnahme der Bauelemente mit einer EMV-Abschirmung (56, 58), wobei das Gehäuse in einem Anschlußbereich (40,55) durch eine Steckvorrichtung zur elektrischen Verbindung der Bauelemente mit Signal- und/oder Stromversorgungsleitungen unterbrochen ist,
c) in der Nähe des Anschlußbereichs angeordnete zusätzliche EMV-Abschirmmittel zum Verhindern oder Verringern des Vordringens von Störungen vom Anschlußbereich her zu den hinter den zusätzlichen Abschirmmitteln angeordneten Bauelementen oder in umgekehrter Richtung, **dadurch gekennzeichnet, daß**
d) die zusätzlichen Abschirmmittel zumindest teilweise dadurch gebildet sind, daß mindestens ein Bauelement (31 - 39, 54), räumlich zwischen dem Anschlußbereich (40, 55) und den sonstigen Bauelementen (41-44) angeordnet ist,
e) welches mit einem Metallgehäuse oder einem die zusätzliche Abschirmfunktion des Gehäuses übernehmenden metallischen Bestandteil versehen ist.

2. Baueinheit nach Anspruch 1, dadurch gekennzeichnet, daß als das mindestens teilweise die Abschirmung bildende Bauelement (31 - 39, 54) ein in der Baueinheit erforderliches Bauelement verwendet wird.

3. Baueinheit nach Anspruch 1 oder 2, dadurch gekennzeichnet, daß mehrere Bauelemente (31 - 39, 54) mit Metallgehäuse dicht benachbart nebeneinander in einer Reihe zum Zweck des Abschirmens angeordnet sind.

4. Baueinheit nach einem der vorangehenden Ansprüche, dadurch gekennzeichnet, daß die zum Zweck des Abschirmens vorgesehenen Bauelemente (31 bis 39, 54) mindestens annähernd die gleiche Höhe haben.

## Claims

1. An electronic module which comprises:
a) a number of electronic components,
b) a housing (51, 56) having an EMC screen (56, 58) for accommodating the components, whereby the housing is interrupted in a terminal region (40, 55) by a plug arrangement for electrically connecting the components to signal and/or power supply leads,
c) additional EMC screening means which are arranged in the vicinity of the terminal region for preventing or reducing the penetration of interference from the terminal region into the components disposed behind the additional screening means or vice versa, characterised in that
d) the additional screening means are formed at least partially by means of at least one component (31-39, 54) which is disposed spatially between the terminal region (40, 55) and the remaining components (41-44),
e) said one component being provided with a metal housing or a metallic constituent which fulfils the additional screening function of the housing.

2. A module in accordance with Claim 1, characterised in that a component that is required in the module is used as said component (31-39, 54) which at least partially forms said screening means.

3. A module in accordance with Claim 1 or 2, characterised in that a plurality of components (31-39, 54) having metal housings are disposed very close together in a row for the purposes of providing said screening means.

4. A module in accordance with any of the preceding Claims, characterised in that the components (31-39, 54) used for the purposes of providing said screening means are at least approximately of the same height.

## Revendications

1. Module électronique, qui comporte:
a) un nombre de composants électroniques,
b) un boîtier (51, 56) pour loger les composants comportant un blindage EMV (56, 58), le boîtier étant interrompu dans une zone de raccordement (40, 55) par un dispositif à enfichage pour la liaison électrique des composants avec des lignes de transmission de signaux et/ou d'alimentation en courant,
c) des moyens de blindage EMV supplémentaires disposés à proximité de la zone de raccordement, servant à empêcher ou à réduire la pénétration de parasites depuis la zone de raccordement en direction des composants disposés en arrière des moyens de blindage supplémentaires, ou dans la direction inverse,
caractérisé en ce que
d) les moyens de blindage supplémentaires sont formés au moins en partie par le fait qu'au moins un composant (31-39, 54) est disposé spatialement entre la zone de raccordement (40, 55) et les autres composants (41-44),
e) ce composant étant pourvu d'un boîtier métallique ou d'une partie métallique qui assume la fonction de blindage supplémentaire du boîtier.

2. Module selon la revendication 1, caractérisé en ce qu'on utilise comme composant (31-39, 54) formant au moins en partie le blindage, un composant nécessaire dans le module.

3. Module selon la revendication 1 ou 2, caractérisé en ce que plusieurs composants (31-39, 54) comportant un boîtier métallique sont disposés en étant serrés les uns à côté des autres suivant une rangée pour former le blindage.

4. Unité de construction selon l'une des revendications précédentes, caractérisée en ce que les composants (31 à 39, 54), qui sont prévus pour réaliser le blindage, possèdent au moins approximativement la même hauteur.
